# EUROPÄISCHE PATENTSCHRIFT

(11) **EP 4 591 076 B1**
(45) Veröffentlichungstag und Bekanntmachung des Hinweises auf die Patenterteilung: **03.12.2025**
(21) Anmeldenummer: 24790254.7
(22) Anmeldetag: 06.09.2024
(51) Int. Cl.: G01R 31/00, G01R 31/28

(54) **PRÜFSYSTEM UND VERFAHREN ZUR ERFASSUNG EINES BETRIEBSVERHALTENS WENIGSTENS EINER ELEKTRISCHEN DOMÄNE EINES FAHRZEUGS**
TESTING SYSTEM AND METHOD FOR DETECTING OPERATING BEHAVIOUR OF AT LEAST ONE ELECTRICAL DOMAIN OF A VEHICLE
SYSTÈME D'ESSAI ET PROCÉDÉ DE DÉTECTION DU COMPORTEMENT DE FONCTIONNEMENT D'AU MOINS UN DOMAINE ÉLECTRIQUE D'UN VÉHICULE

(30) Priorität: 08.09.2023 AT 507272023
(43) Veröffentlichungstag der Anmeldung: 30.07.2025
(73) Patentinhaber: AVL List GmbH, 8020 Graz (AT)
(72) Erfinder: HAMMERER, Horst, 88161 Lindenberg (DE); SCHMIDT, Martin, 63225 Langen (DE)
(86) Internationale Anmeldenummer: PCT/AT2024/060343
(87) Internationale Veröffentlichungsnummer: WO 2025/050159

(56) Entgegenhaltungen:
- CN-A- 111 487 496
- CN-A- 112 557 711
- CN-U- 207 832 976
- KR-B1- 102 422 038

## Beschreibung

Die vorliegende Erfindung betrifft ein Prüfsystem und Verfahren zur Durchführung eines Testbetriebs und zur Erfassung eines Betriebsverhaltens wenigstens einer elektrischen Domäne eines Fahrzeugs.

Das Prüfsystem findet Anwendung in der Produktentwicklung für Komponenten in einem elektrischen Antriebsstrang, Komponenten eines DC-Bordnetzes, das mit dem Antriebsstrang elektrisch verbunden ist, sowie für andere elektrische Komponenten und elektrische Netzwerke eines Fahrzeugs.

Es sind Prüfsysteme zum Testen von Prüflingen bekannt, insbesondere in Bezug auf einen Inverter zur Umformung einer Antriebsleistung und Ansteuerung von Phasenströmen eines elektrischen Traktionsmotors, bei denen Komponenten wie eine Traktionsbatterie durch einen Batterieemulator ersetzt werden. Derartige Batterieemulatoren bilden insbesondere einen Leistungsabgabe einer Batterie zu dem Inverter-Prüfling in Abhängigkeit eines virtuellen Ladezustands oder State of Charge (SOC) oder eines Innenwiderstands der Batterie nach. In der Praxis bestehen jedoch zahlreiche weitere Einflüsse auf die Leistungsflüsse und elektrischen Systeme.

Beispielsweise offenbart die Patentschrift KR 102422038 B1 einen virtuellen Stromversorgungssystem-Emulator, der mindestens eine elektronische Vorrichtung und elektronische Bauteile umfasst, die die elektrischen Ein- und Ausgangseigenschaften eines Teils der elektrischen Systemkomponenten eines Fahrzeugs originalgetreu nachbilden. Ferner umfasst er mindestens ein reales Bauteil für einen anderen Teil der elektrischen Systemkomponenten des Fahrzeugs und eine elektrische Verbindung zwischen den elektronischen Vorrichtungen und elektronischen Bauteilen und dem mindestens einen realen Bauteil, die die elektrischen Eigenschaften, den Betrieb und die Funktionen der elektrischen/elektronischen Komponenten eines tatsächlichen Fahrzeugs nachbildet.

Weiter offenbart das Dokument CN 112557711 A einen Prüfstand für die elektromagnetische Verträglichkeit und ein Verfahren zum Prüfen einer Hochvolt-Systembaugruppe eines elektrischen Personenkraftwagens. Der Prüfstand umfasst die Hochvolt-Systembaugruppe, wobei die Hochvolt-Systembaugruppe eine Leistungsbatterie, einen Hochvolt-Verteilerkasten, einen Motorsteuergerät und einen Motor/Getriebe umfasst, die über Hochvolt-Kabelbäume sequenziell miteinander verbunden sind. Der Hochspannungsverteilerkasten ist über Hochspannungs-Kabelbäume ferner mit einem fahrzeugseitigen Ladegerät und einer elektrischen Heizung verbunden.

Ferner ist aus dem Dokument CN 207832976 U ein Teststandsystem für Antriebsbatterien und Batteriemanagement bekannt. Es umfasst eine Kalibrierungsmessvorrichtung, ein Batteriemanagementsystem, einen Antriebsbatteriesatz, ein Hardware-inthe-Loop-Simulationssystem, einen Test-PC-Host, eine Hoch- und Niederspannungs-Trennvorrichtung, einen DC/DC-Wandler, eine Lade- und Entladevorrichtung und eine Hoch- und Niederspannungs-Trennvorrichtung. Das Batteriemanagementsystem kommuniziert jeweils mit der Hardware-Kalibrierungsmessvorrichtung, dem Hardware-in-the-Loop-Simulationssystem und dem Steuer-Host.

Schließlich offenbart Dokument CN 111487496 A eine Plattform für die elektromagnetische Verträglichkeitsprüfung auf Systemebene von Antriebssträngen. Sie umfasst eine elektromagnetische Abschirmkammer, ein Messsystem außerhalb der Abschirmkammer, Wanddurchführungen, Antriebswellen, Kupplungen, einen Antriebsstrang, ein Antriebsbatteriesystem, eine Testantenne und ein Testempfangssystem. Die elektromagnetische Abschirmkammer ist fest mit den Wanddurchführungen auf der linken und rechten Seite verbunden.

Im Fahrzeug ist der elektrische Antrieb mit einer Batterie über eine Hochvolt-Leitung verbunden. Eine solche Hochvolt-Spannungsversorgung über Hochvolt führende Leitungen führt aufgrund der Wechselanteile des Mischstromes in diesen Leitungen zur Einkoppelung von Strömen und Spannungen in nahe der Leitungen angeordneten, leitfähigen Elementen des Fahrzeugs. Hierbei ist insbesondere eine Karosserie, häufig aber auch andere zumindest teilweise elektrische Domänen des Fahrzeugs betroffen. Elektrische Domänen des Fahrzeugs sind elektrisch voneinander abgegrenzte Bereiche, wie beispielsweise ein 12V oder 24V führendes Niederspannungssystem, welches von dem Hochvolt-System des Fahrzeugs abgegrenzt ist. Andere Domänen können ein Heizsystem, ein Kühlsystem, oder Sensorsysteme umfassen. Die Stärke der Einkoppelung hängt von den elektrischen und magnetischen Leitfähigkeiten der beteiligten Materialien, den Geometrien der Leitungen und der Karosserie, der Stärke und Frequenz eines Mischstromes bzw. Wechselstroms und anderen Faktoren ab, welche sich häufig nur schwer modellieren lassen. Diese Einkoppelungs-Effekte können durch bekannte Prüfsysteme nicht ausreichend nachgebildet werden.

Es ist eine Aufgabe der Erfindung eine Technik in einem Prüfstand zur Prüfung einer oder mehrerer elektrischen Domänen eines Fahrzeugs zu schaffen, die es ermöglicht, die elektrischen und magnetischen Effekte eines Hochvolt-Netzes auf die unterschiedlichen elektrischen Domänen eines elektrisch betriebenen Fahrzeugs realistischer abzubilden.

Des Weiteren besteht eine Aufgabe der Erfindung darin, dass Wechselwirkungen zwischen unterschiedlichen elektrischen Domänen des Fahrzeugs realistisch nachgebildet werden. Eine weitere Aufgabe der Erfindung besteht darin, dass eine solche Nachbildung besonders einfach erfolgen kann, ohne dass ein vollständiges Fahrzeug oder wesentliche Teile des Fahrzeugs im Prüfsystem real vorhanden sein müssen.

Die voranstehenden Aufgaben werden gelöst durch ein Prüfsystem mit den Merkmalen des Anspruchs 1 und ein Verfahren mit den Merkmalen des Anspruchs 15. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit der erfindungsgemäßen Prüfsystem und jeweils umgekehrt, sodass bezüglich der Offenbarung zu den einzelnen Erfindungsaspekten stets wechselseitig Bezug genommen wird beziehungsweise werden kann.

Das erfindungsgemäße Prüfsystem dient zur Durchführung eines Testbetriebs und zur Erfassung eines Betriebsverhaltens wenigstens einer elektrischen Domäne eines Fahrzeugs mit einer Karosserie. Dazu umfasst das Prüfsystem eine Spannungsquelle, die insbesondere einen an ein Stromnetz, angeschlossen Gleichspannungszwischenkreis aufweist, ein erstes Emulatormodul zur Emulation einer elektrischen Komponente einer ersten elektrischen Domäne, und ein zweites Emulatormodul zur Emulation einer zweiten elektrischen Komponente, die der ersten elektrischen Domäne oder einer zweiten elektrischen Domäne zugeordnet ist. Die erste und zweite elektrische Komponente ist jeweils ein Aktor und/oder ein Sensor.

Die Emulatormodule sind an die Spannungsquelle angeschlossen und umfassen jeweils einen Wandler mit einer modellbasierten Steuerung zur Emulation der elektrischen Komponente, und einen elektrischen Emulatormodulanschluss zum Anschluss an einen Prüfling.

Das Prüfsystem umfasst ferner eine leitfähige Karosseriesubstitutionseinrichtung, die dazu eingerichtet ist, einen an die Emulatormodule anschließbaren Prüfling aufzunehmen, wobei eine elektrische und/oder magnetische Leitfähigkeit der Karosseriesubstitutionseinrichtung der elektrischen und/oder magnetischen Leitfähigkeit der Karosserie des Fahrzeugs nachgebildet ist.

Die elektrische Domäne in einem Fahrzeug bezeichnet einen abgegrenzten Bereich des elektrischen Systems, der durch spezifische Spannungs- und Stromparameter sowie durch bestimmte Funktionalitäten und Kommunikationsprotokolle charakterisiert ist. Jede elektrische Domäne erfüllt spezifische Anforderungen und Aufgaben im Gesamtsystem des Fahrzeugs und ist grundsätzlich durch definierte Schnittstellen von anderen elektrischen Domänen getrennt. Die elektrische Domäne kann als ein abgegrenztes Teilnetzwerk oder Subsystem innerhalb der elektrischen Architektur eines Fahrzeugs beschrieben werden. Die elektrische Domäne des Fahrzeugs kann beispielsweise das elektrische Hochvolt-System, das Niedervolt-System oder ein serielles Bussystem im Fahrzeug sein. In manchen Fahrzeugen ist auch beispielsweise das thermische System derart klar abgegrenzt, dass es als eigene Domäne aufgefasst wird. Der Gleichspannungszwischenkreis ist eine elektrische Einrichtung, die als Energiespeicher mehrere elektrische Netze auf einer zwischengeschalteten Gleichspannungsebene elektrisch koppelt, insbesondere über Umrichter. Jedes der Emulatormodule ist dazu eingerichtet, eine elektrische Komponente des Fahrzeugs zu emulieren, wozu es einen elektrischen Wandler aufweist, der im Betrieb derart gesteuert wird, dass er die elektrischen Eigenschaften der elektrischen Komponente nachbildet. Hierzu dient eine modellbasierte Steuerung, welche die elektrische Komponente nachbildet. Die leitfähige Karosseriesubstitutionseinrichtung dient als Substitut für die Karosserie und kann im Wesentlichen aus einer leitfähigen Platte bestehen. Insbesondere kann die Platte auch aus einem nichtleitenden Material bestehen, auf das eine leitfähige Schicht aufgebracht ist. In dieser Form der Platte kann die Karosseriesubstitutionseinrichtung dazu eingerichtet sein, auf Ihrer Oberseite wenigstens einen Prüfling aufzunehmen. Die magnetische Leitfähigkeit, die auch als magnetische Permeabilität bezeichnet wird, und die elektrische Leitfähigkeit der Karosseriesubstitutionseinrichtung können insbesondere über die gewählten Materialien der Platte und/oder deren Beschichtung derart angepasst werden, dass sie den elektrischen und/oder magnetischen Leitfähigkeiten der Karosserie nachgebildet ist. Das Nachbilden der elektrischen und/oder magnetischen Eigenschaften bedeutet insbesondere, dass sich die genannten jeweiligen Eigenschaften im Wesentlichen entsprechen. Die elektrische Leitfähigkeit kann insbesondere auch die komplexe elektrische Leitfähigkeit sein. Die magnetische Leitfähigkeit kann insbesondere auch die komplexe magnetische Leitfähigkeit, also die komplexe Permeabilität sein. Eine Entsprechung im Wesentlichen ist weit auszulegen. In der erfindungsgemäßen Prüfvorrichtung kann die Nachbildung von elektrischen und magnetischen Eigenschaften einer Karosserie aus Metall dagegen bereits durch eine Metallplatte erreicht werden, selbst wenn ein anderes Metall und eine von der Karosserie abweichende Form verwendet wird. Die Emulation funktioniert für viele Anwendungen auch dann ausreichend genau, wenn sich die elektrischen und magnetischen Leitfähigkeiten von Karosserie und Karosseriesubstitutionseinrichtung nicht genau gleich verhalten oder sogar deutlich voneinander abweichen. Für die Erfindung ist nicht wesentlich, dass die genauen Werte der elektrischen und magnetischen Leitfähigkeiten der Karosserie durch die Karosseriesubstitutionseinrichtung nachgebildet werden, sondern, dass diese überhaupt nachgebildet werden.

Um der elektromagnetischen Charakteristik eines realen Fahrzeugrahmens besonders gut zu entsprechen, kann die leitfähige Karosseriesubstitutionseinrichtung ein ferromagnetisches elektrisch leitfähiges Material, insbesondere magnetischen Edelstahl umfassen. Damit bilden sich auch die magnetischen Wechselfelder aufgrund der elektrischen Ströme in den Leistungskabeln realitätsnah aus. Die magnetischen Wechselfelder sind erheblich für Wechselwirkungen zwischen den Kabeln verantwortlich.

Der Erfindung liegt die überraschende Erkenntnis zugrunde, dass verkoppelungs-Effekte einer elektrischen Domäne eines elektrisch betriebenen Fahrzeugs aufgrund elektromagnetischer Wechselfelder in besonders einfacher Weise durch Emulatormodule und einer leitfähigen Karosseriesubstitutionseinrichtung abgebildet werden kann.

Vorzugsweise kann bei dem Prüfsystem vorgesehen sein, dass die Karosseriesubstitutionseinrichtung über eine Reifensubstitutionseinrichtung mit einem Erdpotential in elektrischer Verbindung steht. Die Reifensubstitutionseinrichtung besitzt eine Impedanz mit hohem ohmschen Widerstand. Als hoher Widerstand wird ein Widerstand ab 1kΩ bezeichnet. Der Widerstand kann bis zu einigen MΩ betragen.

Hierdurch können die elektrischen Eigenschaften der Karosserie noch genauer nachgebildet werden. Die teilweise isolierende Reifensubstitutionseinrichtung kann zusammen mit der Karosseriesubstitutionseinrichtung vorzugsweise in Form eines Tisches aufgebaut werden, wobei die Reifensubstitutionseinrichtung als Tischbein oder Tischbeine eine teilweise Isolation zum Erdpotential entsprechend den Reifen des Fahrzeugs bildet und die Karosseriesubstitutionseinrichtung eine Tischplatte bildet. Bevorzugt kann vorgesehen sein, dass eine elektrische und/oder magnetische Leitfähigkeit der Reifensubstitutionseinrichtung der elektrischen und/oder magnetischen Leitfähigkeit eines oder mehrerer Reifen nachgebildet ist. Die elektrische Leitfähigkeit kann insbesondere auch die komplexe elektrische Leitfähigkeit sein. Die magnetische Leitfähigkeit kann insbesondere auch die komplexe magnetische Leitfähigkeit, also die komplexe Permeabilität sein.

Vorteile werden erreicht, wenn das Prüfsystem ferner umfasst: eine Domänensteuervorrichtung zur Erzeugung und Ausgabe von Steuersignalen für die Emulatormodule, um ein oder mehrere Domänen des Fahrzeugs zu simulieren, wobei die Steuersignale in Abhängigkeit von in einem Domänenmodell hinterlegten Emulationsparametern erzeugt werden.

Hierdurch lässt sich die Steuerung des Prüfsystems beschleunigen, vereinfachen und automatisieren. Ferner können komplexere Prüfläufe durchgeführt werden.

Weitere Vorteile werden erreicht, wenn das Prüfsystem ferner umfasst: ein oder mehrere weitere Emulatormodule, zur Emulation einer oder mehrerer elektrischen Komponente, die der ersten elektrischen Domäne, der zweiten elektrischen Domäne, einer dritten elektrischen Domäne und/oder einer weiteren elektrischen Domäne des Fahrzeugs zuzuordnen ist oder sind.

Durch die ein oder mehreren weiteren Emulatormodule kann insbesondere das vollständige elektrische System des Fahrzeugs nachgebildet werden, umfassend alle elektrischen Domänen des Fahrzeugs.

Insbesondere ist von Vorteil, wenn das erste Emulatormodul ein Batterie-Emulatormodul zur Emulation einer Fahrzeugbatterie und/oder ein Ladeanschluss-Emulatormodul zur Emulation eines Ladeanschlusses umfasst.

Das Batterie-Emulatormodul und/oder das Ladeanschluss-Emulatormodul sind dazu eingerichtet wesentliche Elemente des Hochvolt-Systems zu emulieren. Im Hochvolt-System sind die Verkoppelungs-Effekte aufgrund der hohen übertragenen elektrischen Leistung besonders stark und daher besonders relevant. Eine Emulation von Komponenten des Hochvolt-Systems hat daher besonders großen Einfluss auf das Emulationsergebnis.

Gemäß einem weiteren vorteilhaften Aspekt der Erfindung umfasst die elektrische Domäne, oder, im Fall von mehreren elektrischen Domänen, umfassen die elektrischen Domänen, ein Hochvolt-System, ein Niedervolt-System, ein thermisches System und/oder Signal- und Bussysteme des Fahrzeugs.

Das Hochvolt-System kann beispielsweise ein 400 V System oder ein 800 V System sein. Das Niedervolt-System kann beispielsweise ein 12 V System oder ein 24 V System sein. Das thermische System umfasst insbesondere Heizeinrichtungen und Kühleinrichtungen des Fahrzeugs zur Heizung und/oder Kühlung der Fahrgastzelle und/oder elektrischer Komponenten des Fahrzeugs.

Ferner ist von Vorteil, wenn wenigstens eine der elektrischen Komponenten eine elektrische Antriebseinheit, ein E-Motor, ein Ladeanschluss, ein Kompressor, eine Heizeinrichtung und/oder ein Batteriepack ist.

Vorzugsweise ist wenigstens eines der Emulatormodule ein bidirektionales Emulatormodul.

Mit einem bidirektionalen Emulatormodul lassen sich insbesondere E-Motoren, elektrische Antriebseinheiten und Batterien realitätsnah emulieren.

Weitere Vorteile werden erzielt, wenn wenigstens eines der Emulatormodule einen mehrphasigen Wechselstromausgang, der drei Stränge mit Einphasenwechselspannungen, deren Nullphasenwinkel um 120° zueinander verschoben sind, oder fünf Stränge mit Einphasenwechselspannungen, deren Nullphasenwinkel um 72° zueinander verschoben sind, aufweist.

Hierbei kann vorgesehen sein, dass die Gesamtanzahl der Stränge mit Einphasenwechselspannungen ein Vielfaches von drei oder fünf beträgt.

Ein erheblicher Vorteil der Erfindung kann erzielt werden, wenn wenigstens einer der Emulatormodule einen Multiphasen-Wechselstromausgang mit einer Mehrzahl von Strängen mit Einphasenwechselspannungen, deren Nullphasenwinkel zueinander verschoben sind, aufweist, und einzelne Stränge mit jeweils unterschiedlichen Nullphasenwinkeln zu Bündeln von drei oder fünf Strängen mit konstanter Ausgangsleistung verschaltet sind, bevor Bündel mit konstanter Ausgangsleistung miteinander verschaltet sind.

Der Begriff "bevor" ist örtlich in Stromrichtung zu verstehen. Erfindungsgemäß wird zunächst eine konstante Leistung in einzelnen Bündeln erzeugt, bevor die Bündel mit konstanter Leistung verschaltet werden. Im Unterschied zur alternativen Verschaltungsmöglichkeit eines Multiphasen-Wechselstromausgangs, bei welchem Stränge mit gleichem Nullphasenwinkel zu Bündeln höherer Leistung von Wechselspannung miteinander verschaltet sind, bevor diese Bündel zu Einheiten mit konstanter Ausgangsleitung verschaltet sind, ermöglicht die erfindungsgemäße Variante einen kompakteren Aufbau der Schaltung. Der kompaktere Aufbau reduziert die Größe von Kommutierungsschleifen deutlich und reduziert dadurch Störsignale, was die Genauigkeit des Prüfsystems erhöht. Auch hier kann vorgesehen sein, dass die Gesamtanzahl der Stränge mit Einphasenwechselspannungen ein Vielfaches von drei oder fünf beträgt.

Weiter vorzugsweise ist vorgesehen, dass die modellbasierte Steuerung dazu eingerichtet ist, auf einen Anschlusspunkt des Prüflings geregelte Steuersignale bereitzustellen.

Mit der Regelung auf den Anschlusspunkt wird die Genauigkeit der Emulation dadurch erhöht, dass elektrische Leitungen, die Teil des Prüfsystems sind und außerhalb des Prüflings angeordnet sind, als Störquelle entfernt werden. Störeffekte von dem Prüfsystem zugehörigen elektrischen Leitungen werden hierdurch, durch die modellbasierte Steuerung ausgeglichen.

Zusätzliche Vorteile werden erreicht, wenn eine Spannungsmesseinrichtung und/oder eine Potentialmesseinrichtung an der Karosseriesubstitutionseinrichtung angeordnet ist.

Weitere Vorteile werden erreicht, wenn das Prüfsystem ferner umfasst: ein Prüflingssimulationsmodell zur Simulation von Komponenten des Prüflings, zur Durchführung einer Validierung von Messergebnissen des Prüfsystems.

Das Prüflingssimulationsmodell ist vorzugsweise ein digitaler Zwilling des Prüflings. Das Prüflingssimulationsmodell bildet eine weitere Prüfebene, die Messergebnisse unabhängig validieren und damit Messfehler reduzieren oder ausschließen und Ursachen von unerwarteten Messergebnissen offenlegen kann.

Gemäß einem weiteren vorteilhaften Aspekt der Erfindung ist vorgesehen, dass die Karosseriesubstitutionseinrichtung als elektrisch leitende Tischplatte mit wenigstens einem als Reifensubstitutionsvorrichtung hochohmigen Tischbein ausgestaltet sind.

Das wenigstens eine hochohmige Tischbein bildet dabei die elektrischen Eigenschaften der Reifen des Fahrzeugs nach. Insbesondere bildet die Reifensubstitutionsvorrichtung die Impedanz des Reifens nach. Üblicherweise hat die Impedanz des Reifens einen hohen ohmschen Anteil. Der elektrische Widerstand der Reifen und damit auch der elektrische Widerstand des Tischbeins ist hoch und kann insbesondere im Bereich von einigen 1 kΩ bis zu einigen MΩ liegen, ist aber vom gewählten Prüfling abhängig und kann auch andere Werte annehmen.

Das gemäß einem zweiten Aspekt der Erfindung gelieferte Verfahren ermöglicht die Erfassung eines Betriebsverhaltens wenigstens einer elektrischen Domäne eines Fahrzeugs. Das Verfahren zeichnet sich durch die folgenden Schritte aus:
a) Bereitstellen eines Prüfsystems nach einem der Ansprüche 1 bis 14,
b) Anordnen eines, elektrische Leitungen umfassenden Prüflings an oder auf der Karosseriesubstitutionseinrichtung, derart, dass die elektrischen Leitungen entsprechend einer Anordnung im Fahrzeug angeordnet sind,
c) Anschließen des Prüflings an die Emulatormodule, und
d) Durchführen eines Prüflaufs mit dem Prüfsystem an dem Prüfling.

Der Kerngedanke des erfindungsgemäßen Verfahrens liegt darin, dass die elektrischen und magnetischen Effekte einer elektrischen Domäne eines Fahrzeugs dadurch emuliert werden können, dass eine ein aus nur wenigen Komponenten, insbesondere Kabeln, Spulen und Kondensatoren bestehender Prüfling auf einer Karosseriesubstitutionseinrichtung angeordnet und mit Emulatormodulen geprüft wird.

Bei dem Verfahren kann vorteilhafterweise vorgesehen sein, dass der Prüfling die elektrische/n Domäne/n eines Hochvolt-Systems und/oder eines Niedervolt-Systems und/oder eines thermischen Systems und/oder eines Signalsystems des Fahrzeugs nachbildet.

Vorzugsweise kann vorgesehen sein, dass der Prüfling Spulen und Kondensatoren aufweist.

Weitere Vorteile werden erreicht, wenn das in Schritt a) des Verfahrens bereitgestellte Prüfsystem ein Prüfsystem nach einem der Ansprüche 3 bis 14 ist und das Verfahren ferner die Schritte umfasst:
e) Erzeugen von Steuersignalen mit der Domänensteuervorrichtung und dem Domänenmodell und
f) Ausgeben der Steuersignale an die Emulatormodule zur Emulation wenigstens einer Domäne.

Weitere Vorteile, Merkmale und Einzelheiten der Erfindung ergeben sich aus der nachfolgenden Beschreibung, in der unter Bezugnahme auf die Zeichnung Ausführungsbeispiele der Erfindung im Einzelnen beschrieben sind. Es zeigt schematisch:

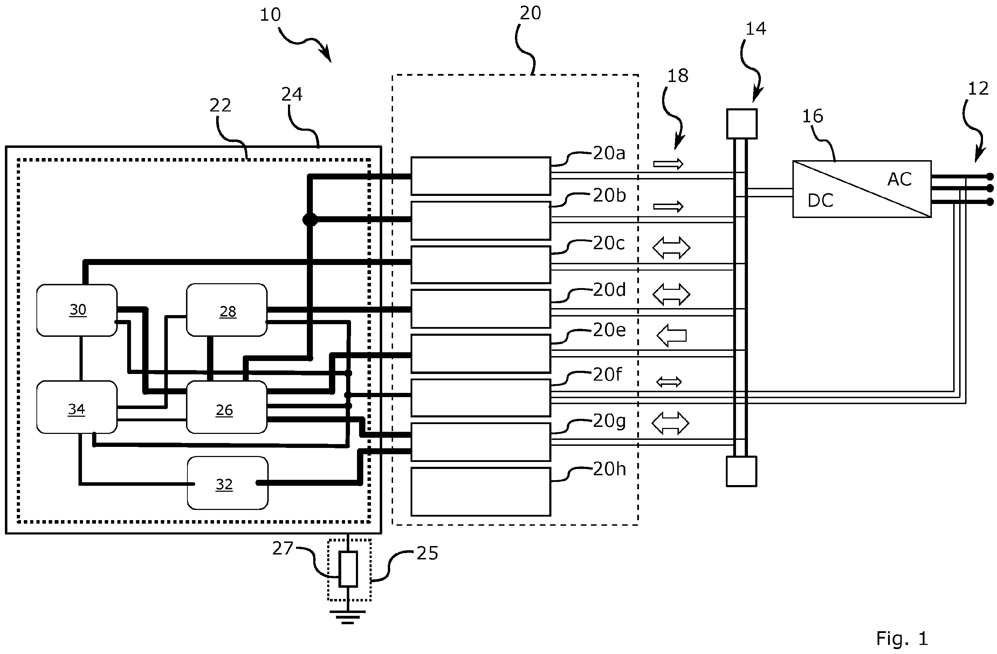

- Fig. 1: ein erfindungsgemäßes Prüfsystems gemäß einer besonderen Ausführungsform der Erfindung, welches an einen Prüfling angeschlossen ist.

Das Prüfsystem 10 dient zur Durchführung eines Testbetriebs und zur Erfassung eines Betriebsverhaltens mehrerer elektrischer Domänen eines Fahrzeugs. In der gezeigten exemplarischen Ausführungsform weist es hierzu als Spannungsquelle einen an ein Stromnetz 12, angeschlossen Gleichspannungszwischenkreis 14 auf. Zwischen Stromnetz 12, und Gleichspannungszwischenkreis 14 ist ein Hochspannungswandler 16 angeordnet. Ferner umfasst das Prüfsystem 10 eine Karosseriesubstitutionseinrichtung 24 und eine Reifensubstitutionseinrichtung 25. Der Gleichspannungszwischenkreis 14 dient der Leistungszuführung zu den Komponenten des Prüfsystems 10 und der Leistungsrückführung von den Komponenten des Prüfsystems 10. Wird das Prüfsystem 10 ideal betrieben, muss ausschließlich Leistung zugeführt werden, wobei sich im Betrieb die zu- und abgeführten Leistungen bis auf systembedingte Verluste im Wesentlichen ausgleichen. Idealerweise muss der Anschluss an das Stromnetz 12 daher nicht rückspeisefähig sein, was die Kosten des Betriebs des Prüfsystems 10 gegenüber anderen Lösungen senkt. Die Leistungsrückführung im Gleichspannungszwischenkreis 14 ist für die in Fahrzeugen üblichen elektrischen Leistung von 10kW bis 2MW ausgelegt, aber in der Auslegung nicht darauf beschränkt.

Vom Gleichspannungszwischenkreis 14 werden Emulatormodule 20 des Prüfsystems 10 mit Strom versorgt. Das Prüfsystem 10 weist hierzu ein erstes Emulatormodul 20a zur Emulation eines Hochspannungskompressors auf. Das erste Emulatormodul 20a ist dem Hochvolt-System, also der Hochspannungsdomäne des Fahrzeugs zugeordnet. Entsprechend der Funktionsweise eines realen Hochspannungskompressors ist das erste Emulatormodul dazu eingerichtet, zu emulieren, dass Leistung vom Fahrzeug, also beispielsweise von einer Fahrzeugbatterie aufgenommen wird, welche im Prüfsystem wiederum vom ersten Emulatormodul 20a an den Gleichspannungszwischenkreis 14 abgegeben werden muss. Die Richtungen und Größen der Leistungsflüsse zwischen Gleichspannungszwischenkreis 14 und Emulatormodulen 20a - 20h sind durch Pfeile 18 angedeutet.

Ein zweites Emulatormodul 20b ist zur Emulation einer zweiten elektrischen Komponente, explizit einer Hochspannungs-Heizeinrichtung eingerichtet. Das zweite Emulatormodul 20b ist ebenfalls dem Hochvolt-System zugeordnet und ebenfalls dazu eingerichtet, lediglich Leistung an den Gleichspannungszwischenkreis 14 abzugeben, aber nicht, Leistung von diesem aufzunehmen.

Die weiteren Emulatormodule sind dazu eingerichtet die folgenden Einheiten zu emulieren. Ein drittes Emulatormodul 20c ist zur Emulation eines ersten Elektromotors eingerichtet. Ein viertes Emulatormodul 20d ist zur Emulation eines zweiten Elektromotors eingerichtet. Der erste und zweite Elektromotor ist als Teil des Antriebsstrangs jeweils dem Hochvolt-System des Fahrzeugs zugeordnet. Entsprechend sind das dritte und vierte Emulatormodul 20c, 20d ebenfalls dem Hochvolt-System des Prüflings 22 zugeordnet. Im Unterschied zum ersten und zweiten Emulatormodul 20a, 20b sind das dritte und vierte Emulatormodul 20c, 20d jeweils dazu eingerichtet, sowohl Leistung vom Gleichspannungszwischenkreis 14 aufzunehmen als auch Leistung an den Gleichspannungszwischenkreis 14 abzugeben, entsprechend den Betriebsmodi "Antrieb" und "Rekuperation" von elektrischen Antriebseinheiten.

Ein fünftes Emulatormodul 20e ist als Ladeanschluss-Emulatormodul zur Emulation eines Ladeanschlusses eingerichtet. Dessen Leistungsfluss ist in der gezeigten exemplarischen Ausführungsform der Erfindung ausschließlich zum Prüfling 22 und damit auch nur monodirektional vom Gleichspannungszwischenkreis 14 zum fünften Emulatormodul 20e ausgerichtet. Auch das fünfte Emulatormodul 20e ist dem Hochvolt-System und damit der gleichen Domäne wie die ersten bis vierten Emulatormodule 20a-20d zugeordnet. In anderen Ausführungsformen kann vorgesehen sein, dass ein AC-Ladeanschluss und ein DC-Ladeanschluss im Fahrzeug vorhanden ist und in beide Ladeanschlüsse emuliert werden. Weiterhin kann in anderen Ausführungsformen das Ladeanschluss-Emulatormodul bidirektional ausgeführt sein, um eine Funktionsweise zur Einspeisung von Strom in ein Stromnetz abzubilden, mit der elektrische Fahrzeuge das Stromnetz stabilisieren können.

Ein sechstes Emulatormodul 20f ist zur Emulation eines 12V Bordnetzes eingerichtet. Das 12V Bordnetz des Fahrzeugs operiert, bis auf induktive Kopplungen, unabhängig vom Hochvolt-System, womit das sechste Emulatormodul 20f einer davon separaten Domäne zugeordnet ist.

Ein siebtes Emulatormodul 20g ist zur Emulation einer Fahrzeugbatterie eingerichtet und der Domäne des Hochvolt-Systems zugeordnet. Das siebte Emulatormodul 20g ist, entsprechend der Emulation von Lade- und Entladevorgängen zur Aufnahme und Abgabe von elektrischer Leistung eingerichtet.

Das achte Emulatormodul 20h ist dazu eingerichtet, die dem Prüfstand zugeordnete Konditionierung zu emulieren. Das achte Emulatormodul ist damit Teil der Emulation des thermischen Systems.

Die Emulatormodule 20 sind jeweils an den Gleichspannungszwischenkreis 14 angeschlossen und umfassen jeweils einen Wandler mit einer modellbasierten Steuerung zur Emulation der jeweiligen elektrischen Komponente wobei der Wandler über einen elektrischen Emulatormodulanschluss (nicht explizit dargestellt) an einen Prüfling 22 angeschlossen ist.

Der Prüfling 22 kann elektrische Leitungen umfassen. Insbesondere kann der Prüfling ferner leistungselektronische Komponenten wie Umrichter und elektrische Speicher wie Spulen und Kondensatoren umfassen. Er ist im Betrieb auf einer leitfähigen Karosseriesubstitutionseinrichtung 24 angeordnet. Ferner ist die Reifensubstitutionseinrichtung 25 an der Karosseriesubstitutionseinrichtung 24 angeordnet und umfasst einen komplexen Widerstand 27, der mit einem Erdpotential verbunden ist. Im gezeigten Ausführungsbeispiel umfasst der Prüfling 22 ferner mehrere elektronische Steuerungseinheiten, welche zur Durchführung eines Prüflaufs ebenfalls an der Karosseriesubstitutionseinrichtung 24 angeordnet sind. Zentral umfasst der Prüfling 22 eine Leistungsverteileinheit 26, die über Leitungen des Hochvolt-Systems an das erste Emulatormodul, 20a, das zweite Emulatormodul 20b und das siebte Emulatormodul 20g, angeschlossen ist. Ferner umfasst der Prüfling 22 einen Front-Inverter 28 und einen Heck-Inverter 30, welche Teil des Antriebsstrangs und ebenfalls über Leitungen des Hochvolt-Systems an die Leistungsverteileinheit 26 angeschlossen sind. Ein Batteriemanagementsystem 32 ist zur Emulation einer Fahrzeugbatterie eingerichtet und an das siebte Emulatormodul 20g angeschlossen.

Schließlich umfasst der Prüfling 22 ein über serielle Verbindungsleitungen verschaltetes Fahrzeugsteuergerät (vehicle control unit, VCU) 34. Das Fahrzeugsteuergerät 34 ist zur Steuerung mit dem Batteriemanagementsystem 32, der Leistungsverteileinheit 26, dem Front-Inverter 28 und dem Heck-Inverter 30 verbunden und ist dazu eingerichtet, diese realen Einheiten des Prüflings zu steuern. Das Fahrzeugsteuergerät 34 nutzt hierzu eine modellbasierte Steuerung.

Das dritte und das vierte Emulatormodul 20c, 20d sind mit dem Heck-Inverter 30, bzw. dem Front Inverter 28 verbunden.

Der Prüfling 22 ist zur Durchführung eines Prüflaufs derart auf der Karosseriesubstitutionseinrichtung 24 angeordnet, dass dessen elektrische Einheiten, wie Kabel, Spulen, Kondensatoren, etc. deren Anordnung im Fahrzeug im Wesentlichen entsprechen.

Die voranstehenden Erläuterungen zu den Ausführungsformen beschreiben die vorliegende Erfindung ausschließlich im Rahmen von Beispielen.

### Bezugszeichenliste

- 10: Prüfsystem
- 12: Stromnetz
- 14: Gleichspannungszwischenkreis
- 16: Hochspannungswandler
- 18: Pfeile
- 20: Emulatormodule
- 20a: erstes Emulatormodul
- 20b: zweites Emulatormodul
- 20c: drittes Emulatormodul
- 20d: viertes Emulatormodul
- 20e: fünftes Emulatormodul
- 20f: sechstes Emulatormodul
- 20g: siebtes Emulatormodul
- 20h: achtes Emulatormodul
- 22: Prüfling
- 24: Karosseriesubstitutionseinrichtung
- 25: Reifensubstitutionseinrichtung
- 26: Leistungsverteileinheit
- 27: komplexer Widerstand
- 28: Front-Inverter
- 30: Heck-Inverter
- 32: Batteriemanagementsystem
- 34: Fahrzeugsteuergerät

## Patentansprüche

1. Prüfsystem (10) zur Durchführung eines Testbetriebs und zur Erfassung eines Betriebsverhaltens wenigstens einer elektrischen Domäne eines Fahrzeugs mit einer Karosserie, aufweisend:
eine Spannungsquelle, die insbesondere einen an ein Stromnetz (12), angeschlossen Gleichspannungszwischenkreis (14) aufweist,
ein erstes Emulatormodul (20a) zur Emulation einer elektrischen Komponente einer ersten elektrischen Domäne, wobei die erste elektrische Komponente ein Aktor und/oder ein Sensor ist,
ein zweites Emulatormodul (20b) zur Emulation einer zweiten elektrischen Komponente, die der ersten elektrischen Domäne oder einer zweiten elektrischen Domäne zugeordnet ist, wobei die zweite elektrische Komponente ein Aktor und/oder ein Sensor ist,
wobei die Emulatormodule (20a-g) an die Spannungsquelle angeschlossen sind und jeweils einen Wandler mit einer modellbasierten Steuerung zur Emulation der elektrischen Komponente umfassen;
**gekennzeichnet durch**:
eine leitfähige Karosseriesubstitutionseinrichtung (24), die dazu eingerichtet ist, einen an die Emulatormodule anschließbaren Prüfling (22) aufzunehmen und wobei eine elektrische und/oder magnetische Leitfähigkeit der Karosseriesubstitutionseinrichtung (24) einer elektrischen und/oder magnetischen Leitfähigkeit der Karosserie des Fahrzeugs nachgebildet ist.

2. Prüfsystem (10) nach einem der vorhergehenden Ansprüche, wobei die Karosseriesubstitutionseinrichtung (24) über eine teilweise isolierende Reifensubstitutionseinrichtung (25) mit einem Erdpotential in elektrischer Verbindung steht.

3. Prüfsystem (10) nach Anspruch 1 oder 2, ferner umfassend eine Domänensteuervorrichtung zur Erzeugung und Ausgabe von Steuersignalen für die Emulatormodule (20a-g), um ein oder mehrere Domänen des Fahrzeugs zu simulieren, wobei die Steuersignale in Abhängigkeit von in einem Domänenmodell hinterlegten Emulationsparametern erzeugt werden.

4. Prüfsystem (10) nach einem der vorhergehenden Ansprüche, ferner umfassend ein oder mehrere weitere Emulatormodule (20a-g), zur Emulation von eine oder mehreren elektrischen Komponenten, die der ersten elektrischen Domäne, der zweiten elektrischen Domäne, einer dritten elektrischen Domäne und/oder einer weiteren elektrischen Domäne des Fahrzeugs zuzuordnen ist oder sind.

5. Prüfsystem (10) nach einem der vorhergehenden Ansprüche, wobei das erste Emulatormodul (20a) ein Batterie-Emulatormodul zur Emulation einer Fahrzeugbatterie und/oder ein Ladeanschluss-Emulatormodul zur Emulation eines Ladeanschlusses umfasst.

6. Prüfsystem (10) nach einem der vorhergehenden Ansprüche, wobei die elektrische Domäne, oder im Fall von mehreren elektrischen Domänen, die elektrischen Domänen, ein Hochvolt-System, ein Niedervolt-System, ein thermisches System und/oder Signal- und Bussysteme des Fahrzeugs umfasst.

7. Prüfsystem (10) nach einem der vorhergehenden Ansprüche, wobei wenigstens eine der elektrischen Komponenten eine elektrische Antriebseinheit, ein E-Motor, ein Ladeanschluss, ein Kompressor, eine Heizeinrichtung und/oder ein Batteriepack ist.

8. Prüfsystem (10) nach einem der vorhergehenden Ansprüche, wobei wenigstens eines der Emulatormodule (20a-g) ein bidirektionales Emulatormodul ist.

9. Prüfsystem (10) nach einem der vorhergehenden Ansprüche, wobei wenigstens eines der Emulatormodule (20a-g) einen mehrphasigen Wechselstromausgang, der drei Stränge mit Einphasenwechselspannungen, deren Nullphasenwinkel um 120° zueinander verschoben sind, oder fünf Stränge mit Einphasenwechselspannungen, deren Nullphasenwinkel um 72° zueinander verschoben sind, aufweist.

10. Prüfsystem (10) nach einem der vorhergehenden Ansprüche, wobei wenigstens eines der Emulatormodule (20a-g) einen Multiphasen-Wechselstromausgang mit einer Mehrzahl von Strängen mit Einphasenwechselspannungen, deren Nullphasenwinkel zueinander verschoben sind, aufweist, und einzelne Stränge mit jeweils unterschiedlichen Nullphasenwinkeln zu Bündeln von drei oder fünf Strängen mit konstanter Ausgangsleistung verschaltet sind, bevor Bündel mit konstanter Ausgangsleistung miteinander verschaltet sind.

11. Prüfsystem (10) nach einem der vorhergehenden Ansprüche, wobei die modellbasierte Steuerung dazu eingerichtet ist, auf einen Anschlusspunkt des Prüflings (22) geregelte Steuersignale bereitzustellen.

12. Prüfsystem (10) nach einem der vorhergehenden Ansprüche, wobei eine Spannungsmesseinrichtung und/oder eine Potentialmesseinrichtung an der Karosseriesubstitutionseinrichtung (24) angeordnet ist.

13. Prüfsystem (10) nach einem der vorhergehenden Ansprüche, ferner umfassend ein Prüflingssimulationsmodell zur Simulation von Komponenten des Prüflings (22), zur Durchführung einer Validierung von Messergebnissen des Prüfsystems.

14. Prüfsystem (10) nach einem der vorhergehenden Ansprüche, wobei Karosseriesubstitutionseinrichtung (24) und die Reifensubstitutionsvorrichtung als elektrisch leitende Tischplatte mit wenigstens einem hochohmigen Tischbein ausgestaltet sind.

15. Verfahren zur Erfassung eines Betriebsverhaltens wenigstens einer elektrischen Domäne eines Fahrzeugs, umfassend die Schritte:
a) Bereitstellen eines Prüfsystems (10) nach einem der vorhergehenden Ansprüche,
b) Anordnen eines, elektrische Leitungen umfassenden Prüflings an oder auf der Karosseriesubstitutionseinrichtung (24), derart, dass die elektrischen Leitungen entsprechend einer Anordnung im Fahrzeug angeordnet sind,
c) Anschließen des Prüflings (22) an die Emulatormodule, und
d) Durchführen eines Prüflaufs mit dem Prüfsystem (10) an dem Prüfling (22).

## Claims

1. Test system (10) for performing a test operation and for recording the operating behaviour of at least one electrical domain of a vehicle with a body, comprising:
a voltage source, which in particular has a DC link circuit (14) connected to a power supply network (12),
a first emulator module (20a) for emulating an electrical component of a first electrical domain, wherein the first electrical component is an actuator and/or a sensor,
a second emulator module (20b) for emulating a second electrical component associated with the first electrical domain or a second electrical domain, the second electrical component being an actuator and/or a sensor,
the emulator modules (20a-g) being connected to the voltage source and each comprising a converter with a model-based control for emulating the electrical component;
**characterised by**:
a conductive body substitution device (24) which is designed to accommodate a device under test (22) that can be connected to the emulator modules, and wherein an electrical and/or magnetic conductivity of the body substitution device (24) is modelled on an electrical and/or magnetic conductivity of the body of the vehicle.

2. Test system (10) according to one of the preceding claims, wherein the body substitution device (24) is electrically connected to earth potential via a partially insulating tyre substitution device (25).

3. Test system (10) according to claim 1 or 2, further comprising a domain control device for generating and outputting control signals for the emulator modules (20a-g) in order to simulate one or more domains of the vehicle, wherein the control signals are generated as a function of emulation parameters stored in a domain model.

4. Test system (10) according to one of the preceding claims, further comprising one or more additional emulator modules (20a-g) for emulating one or more electrical components that are assignable to the first electrical domain, the second electrical domain, a third electrical domain and/or a further electrical domain of the vehicle.

5. Test system (10) according to one of the preceding claims, wherein the first emulator module (20a) comprises a battery emulator module for emulating a vehicle battery and/or a charging port emulator module for emulating a charging port.

6. Test system (10) according to one of the preceding claims, wherein the electrical domain, or in the case of multiple electrical domains, the electrical domains, comprise a high-voltage system, a low-voltage system, a thermal system and/or signal and bus systems of the vehicle.

7. Test system (10) according to one of the preceding claims, wherein at least one of the electrical components is an electric drive unit, an electric motor, a charging connection, a compressor, a heating device and/or a battery pack.

8. Test system (10) according to one of the preceding claims, wherein at least one of the emulator modules (20a-g) is a bidirectional emulator module.

9. Test system (10) according to one of the preceding claims, wherein at least one of the emulator modules (20a-g) has a multiphase alternating current output comprising three phases with single-phase alternating voltages whose zero phase angles are shifted by 120° relative to each other, or five phases with single-phase alternating voltages whose zero phase angles are shifted by 72° relative to each other. -phase alternating voltages whose zero phase angles are shifted by 72° relative to each other.

10. Test system (10) according to one of the preceding claims, wherein at least one of the emulator modules (20a-g) has a multiphase alternating current output with a plurality of strands with single-phase alternating voltages whose zero phase angles are shifted relative to each other, and individual phases with different zero phase angles are connected to bundles of three or five phases with constant output power before bundles with constant output power are connected to each other.

11. Test system (10) according to one of the preceding claims, wherein the model-based control is designed to provide regulated control signals to a connection point of the device under test (22).

12. Test system (10) according to one of the preceding claims, wherein a voltage measuring device and/or a potential measuring device is arranged on the body substitution device (24).

13. Test system (10) according to one of the preceding claims, further comprising a test object simulation model for simulating components of the device under test (22) in order to perform a validation of measurement results of the test system.

14. Test system (10) according to one of the preceding claims, wherein the body substitution device (24) and the tyre substitution device are designed as an electrically conductive table top with at least one high-resistance table leg.

15. Method for detecting the operating behaviour of at least one electrical domain of a vehicle, comprising the steps:
a) Providing a test system (10) according to one of the preceding claims,
b) arranging a test specimen comprising electrical cables on or at the body substitution device (24) in such a way that the electrical cables are arranged in accordance with their arrangement in the vehicle,
c) connecting the device under test (22) to the emulator modules, and
d) performing a test run with the test system (10) on the device under test (22).

## Revendications

1. Système de contrôle (10) pour effectuer un test de fonctionnement et pour enregistrer le comportement en fonctionnement d'au moins un domaine électrique d'un véhicule avec une carrosserie, comprenant:
une source de tension qui comprend notamment un circuit intermédiaire à tension continue (14) raccordé à un réseau électrique (12),
un premier module d'émulation (20a) pour émuler un composant électrique d'un premier domaine électrique, le premier composant électrique étant un actionneur et/ou un capteur,
un deuxième module d'émulation (20b) pour émuler un deuxième composant électrique associé au premier domaine électrique ou à un deuxième domaine électrique, le deuxième composant électrique étant un actionneur et/ou un capteur,
les modules d'émulation (20a-g) étant raccordés à la source de tension et comprenant chacun un convertisseur avec une commande basée sur un modèle pour émuler le composant électrique;
**caractérisé par** :
un dispositif de substitution de carrosserie conducteur (24) qui est conçu pour recevoir un échantillon à tester (22) pouvant être connecté aux modules d'émulation, et dans lequel une conductivité électrique et/ou magnétique du dispositif de substitution de carrosserie (24) est reproduite à partir d'une conductivité électrique et/ou magnétique de la carrosserie du véhicule.

2. Système de contrôle (10) selon l'une des revendications précédentes, dans lequel le dispositif de substitution de carrosserie (24) est en liaison électrique avec un potentiel de terre via un dispositif de substitution de pneu partiellement isolant (25).

3. Système de contrôle (10) selon la revendication 1 ou 2, comprenant en outre un dispositif de commande de domaine pour générer et émettre des signaux de commande destinés aux modules d'émulation (20a-g) afin de simuler un ou plusieurs domaines du véhicule, les signaux de commande étant générés en fonction de paramètres d'émulation enregistrés dans un modèle de domaine.

4. Système de contrôle (10) selon l'une des revendications précédentes, comprenant en outre un ou plusieurs modules d'émulation supplémentaires (20a-g) pour émuler un ou plusieurs composants électriques qui sont associés au premier domaine électrique, au deuxième domaine électrique, à un troisième domaine électrique et/ou à un autre domaine électrique du véhicule.

5. Système de test (10) selon l'une des revendications précédentes, dans lequel le premier module d'émulation (20a) comprend un module d'émulation de batterie pour émuler une batterie de véhicule et/ou un module d'émulation de connecteur de charge pour émuler un connecteur de charge.

6. Système de contrôle (10) selon l'une des revendications précédentes, dans lequel le domaine électrique, ou dans le cas de plusieurs domaines électriques, les domaines électriques, comprennent un système haute tension, un système basse tension, un système thermique et/ou des systèmes de signaux et de bus du véhicule.

7. Système de contrôle (10) selon l'une des revendications précédentes, dans lequel au moins l'un des composants électriques est une unité d'entraînement électrique, un moteur électrique, un connecteur de charge, un compresseur, un dispositif de chauffage et/ou un bloc-batterie.

8. Système de test (10) selon l'une des revendications précédentes, dans lequel au moins l'un des modules d'émulation (20a-g) est un module d'émulation bidirectionnel.

9. Système de test (10) selon l'une des revendications précédentes, dans lequel au moins l'un des modules d'émulation (20a-g) présente une sortie de courant alternatif polyphasé qui comporte trois phases avec des tensions alternatives monophasées dont les angles de phase zéro sont décalés de 120° les uns par rapport aux autres, ou cinq phases avec des tensions alternatives monophasées dont les angles de phase zéro sont décalés de 72° les uns par rapport aux autres.

10. Système de test (10) selon l'une des revendications précédentes, dans lequel au moins l'un des modules d'émulation (20a-g) présente une sortie de courant alternatif polyphasé avec une pluralité de phases avec des tensions alternatives monophasées dont les angles de phase zéro sont décalés les uns par rapport aux autres, et des phases individuelles ayant chacune des angles de phase nuls différents sont interconnectées en faisceaux de trois ou cinq phases avec une puissance de sortie constante avant que des faisceaux avec une puissance de sortie constante ne soient interconnectés les uns aux autres.

11. Système de test (10) selon l'une des revendications précédentes, dans lequel la commande basée sur un modèle est conçue pour fournir des signaux de commande régulés à un point de connexion de l'échantillon testé (22).

12. Système de contrôle (10) selon l'une des revendications précédentes, dans lequel un dispositif de mesure de tension et/ou un dispositif de mesure de potentiel est disposé sur le dispositif de substitution de carrosserie (24).

13. Système de contrôle (10) selon l'une des revendications précédentes, comprenant en outre un modèle de simulation d'échantillon pour simuler des composants de l'échantillon (22), afin d'effectuer une validation des résultats de mesure du système de contrôle.

14. Système de contrôle (10) selon l'une des revendications précédentes, dans lequel le dispositif de remplacement de la carrosserie (24) et le dispositif de remplacement des pneus sont conçus comme un plateau de table électriquement conducteur avec au moins un pied de table à haute impédance.

15. Procédé pour enregistrer le comportement en service d'au moins un domaine électrique d'un véhicule, comprenant les étapes suivantes:
a) mise à disposition d'un système de contrôle (10) selon l'une des revendications précédentes,
b) disposition d'un échantillon à tester comprenant des câbles électriques sur ou dans le dispositif de substitution de carrosserie (24) de telle sorte que les câbles électriques soient disposés conformément à une disposition dans le véhicule,
c) raccordement de l'échantillon testé (22) aux modules d'émulation, et
d) réalisation d'un test avec le système de test (10) sur l'échantillon testé (22).
